# EUROPÄISCHE PATENTSCHRIFT

(11) **EP 4 506 699 B1**
(45) Veröffentlichungstag und Bekanntmachung des Hinweises auf die Patenterteilung: **02.09.2026**
(21) Anmeldenummer: 24189132.4
(22) Anmeldetag: 17.07.2024
(51) Int. Cl.: G01R 27/22, G01R 27/02, C25B 1/04

(54) **VERFAHREN UND VORRICHTUNG ZUR ISOLATIONSÜBERWACHUNG EINER WASSERSTOFFELEKTROLYSEANLAGE**
METHOD AND DEVICE FOR INSULATION MONITORING OF A HYDROGEN ELECTROLYSIS INSTALLATION
PROCÉDÉ ET DISPOSITIF DE SURVEILLANCE DE L'ISOLATION D'UNE INSTALLATION D'ÉLECTROLYSE D'HYDROGÈNE

(30) Priorität: 27.07.2023 DE 102023119910
(43) Veröffentlichungstag der Anmeldung: 12.02.2025
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- DE-B3- 102020 104 956
- JP-A- 2009 093 822

## Beschreibung

Die Erfindung betrifft ein Verfahren und eine elektrische Schaltungsanordnung zur Bestimmung eines Isolationswiderstands Riso eines ungeerdeten Stromversorgungssystems, welches eine Wasserstoffelektrolyseanlage mit elektrischer Energie versorgt.

In einem ungeerdeten Stromversorgungssystem - welches auch als isoliertes Netz oder IT-System (isolé terre) bezeichnet wird - darf laut normativer Anforderung nach DIN VDE 0100 Teil 100 kein aktiver Leiter des ungeerdeten Stromversorgungssystems mit Erde leitfähig verbunden sein, um im ersten Fehlerfall auf eine automatische Abschaltung der Stromversorgung in der normativ geforderten Abschaltzeit verzichten zu können. Ausgenommen hiervon sind hinreichend hochohmige Verbindungen der aktiven Leiter mit Erde aus messtechnischen oder funktionalen Gründen, wie sie beispielsweise aus widerstandsgeerdeten IT-Systemen (HRG - high resistance grounded - Systeme) bekannt sind.

Bei einem Isolationsfehler in einem IT-System, wie beispielsweise einem Erdschluss oder einem Körperschluss, wird die Funktion der angeschlossenen elektrischen Verbraucher nicht beeinträchtigt, da sich wegen des im Idealfall unendlich großen Isolationswiderstands zwischen einem aktiven Leiter des IT-Netzes und Erde kein geschlossener Stromkreis ausbilden kann.

Für den Isolationswiderstand des ungeerdeten Stromversorgungssystems - der Widerstand des ungeerdeten Stromversorgungssystems gegen Erde ohne die aus messtechnischen oder funktionalen Gründen zwischen den aktiven Leitern und Erde im IT-System eingebrachten ohmschen Widerstände - gelten normativ beispielsweise nach DIN VDE 0100 Teil 530 Isolationswiderstände von 100 Ohm/Volt Nennspannung als unkritisch. In diesem Fall fließen nur 10mA Fehlerstrom über die Isolierstrecke in den Schutzleiter.

Der Isolationswiderstand des ungeerdeten Stromversorgungssystems muss daher mit einem normgerechten Isolationsüberwachungsgerät (IMD) dauernd überwacht werden, wobei in Abhängigkeit des angewandten Messverfahrens, beispielsweise bei einem impulsförmigen, getakteten Messstrom, im Abstand einer IMD-Berechnungsperiode ein aktueller Isolationswiderstandswert bestimmt wird. Durch einen möglichen weiteren Fehler an einem anderen aktiven Leiter würde eine Fehlerschleife entstehen und der dabei fließende Fehlerstrom hätte in Verbindung mit einer Überstromschutzeinrichtung eine Abschaltung der Anlage mit Betriebsstillstand zur Folge.

Für widerstandsgeerdete IT-Systeme sind auf dem Markt Isolationsüberwachungssysteme verfügbar, welche den Wert des fest installierten, nicht dynamischen, Widerstands zwischen dem Neutraleiter eines IT-Trafos und Erde nach manueller Eingabe rechnerisch bei der Bestimmung des Isolationswiderstands für das IT-System berücksichtigen.

Für nichtlineare oder sich dynamisch ändernde, betriebsmäßig vorhandene, parallel zum Isolationswiderstand liegende Widerstände zwischen den aktiven Leitern und Erde ist dieses Verfahren nicht geeignet.

Auch bei der Wasserstoffelektrolyse mit PEM-Stack-Elektrolyseuren (Protonenaustauschmembranelektrolyse oder Polymer-Elektrolyt-Membran-Elektrolyse), aber potenziell ebenso bei der Wasserstoffelektrolyse mit alkalischen Elektrolyseuren, erfolgt die Stromversorgung vorrangig mit der Netzform IT-System.

Eine Freischaltung des eigentlichen Elektrolyseprozesses, also das Aufschalten eines DC-Laststroms, der die Elektrolyse des Wassers bewirkt, erfolgt betriebsmäßig erst, wenn von dem Isolationsüberwachungsgerät ein für die Anlage als unkritisch zu betrachtender Isolationswiderstand festgestellt wird.

Isolationsüberwachungssysteme üben somit aufgrund der oben beschriebenen Wartezeit bis zu einer Freigabe der Elektrolyse einen negativen Einfluss auf die Wirtschaftlichkeit der Anlage aus. Um diese Produktivitätsminderung auszugleichen, bestehen in der betrieblichen Praxis übliche Vorgehensweisen darin,
das Überwachungssystem zu überbrücken oder abzuklemmen,
den Grenzwert des Überwachungssystems so zu verändern, dass eine Abschaltung kaum noch erfolgt,
das Überwachungssystem mit Zeitverzögerung erst scharf zu schalten, wenn die Anlage betrieblich in einem unkritischen, eingeschwungenen Zustand ist oder
aus einem ungeerdet betriebenen System ein geerdet betriebenes System zu machen, bei dem auch größere Ströme über das Verbrauchswassersystem erst auffallen, wenn ein Unfall oder ein Störfall auftritt.

Die Bestimmung des Isolationswiderstands des IT-Systems erfordert insbesondere bei der PEM-Wasserstoffelektrolyse besondere Maßnahmen, da aus funktionalen Gründen eine elektrolytisch leitfähige Verbindung des Verbrauchswassers mit den aktiven Leitern des IT-Systems besteht.

Der elektrische Widerstand dieser leitfähigen Verbindung des Verbrauchswassers hängt u.a. von der Geometrie der Wasserzuführung und von der Leitfähigkeit des Verbrauchswassers ab.

Dieser funktionale Widerstand des Verbrauchswassers liegt für das Isolationsüberwachungsgerät messtechnisch parallel zu dem eigentlich zu bestimmenden Isolationswiderstand der Isolierstrecke der aktiven Leiter des ungeerdeten Stromversorgungssystems gegen Erde.

Ist der funktionale Widerstand des Verbrauchswassers niederohmiger als der geforderte Isolationswiderstand des IT-Systems, so kann der Isolationswiderstandswert messtechnisch nach dem Stand der Technik nicht hinreichend genau ermittelt werden, da der von dem Isolationsüberwachungsgerät ermittelte Wert hauptsächlich vom Widerstand des Verbrauchswassers bestimmt wird und somit keine Auskunft über den tatsächlichen Zustand der Isolierstrecke des IT-Systems liefert.

Da eine zu starke Mineralisierung des Verbrauchswassers für die Wasserstoffelektrolyse nicht optimal ist, erfolgt zu Beginn des Hochfahrens der Wasserstoffelektrolyseanlage bevor der DC-Laststrom freigegeben wird eine Demineralisierung des Verbrauchswassers. Bis die Demineralisierung des Verbrauchswassers voll wirksam ist, kann ein Zeitraum bis zu 30min vergehen.

Mit zunehmender Wirksamkeit des Demineralisierungsprozesses des Verbrauchswassers nimmt die elektrische Leitfähigkeit des Verbrauchswassers ab und der funktionale Widerstand des Verbrauchswassers gegen Erde nimmt zu.

Im eingeschwungenen Zustand der Demineralisierung ist die Leitfähigkeit des Verbrauchswassers typischerweise so niedrig, dass der vom Isolationsüberwachungsgerät ermittelte Wert hauptsächlich vom Isolationswiderstand des IT-Systems und nicht vom funktionalen Widerstand des Verbrauchswassers gegen Erde bestimmt wird.

Nach dem Stand der Technik kann ein Isolationsüberwachungsgerät nur einen Gesamt-Isolationswiderstand in Form der Parallelschaltung aus dem eigentlich zu bestimmenden Isolationswiderstandswert des IT-Systems und dem funktionalen Widerstand des Verbrauchswassers bestimmen.

Wie oben dargelegt, erfolgt somit bei dem Hochfahren eine Freischaltung des Wasserstoffelektrolyseprozesses erst, nachdem durch den Demineralisierungsprozess des Verbrauchswassers ein hinreichend hoher funktionaler Widerstand des Verbrauchswassers gegen Erde erreicht ist.

Bei fluktuierenden Wasserstoffelektrolyseanwendungen mit häufig neu startender Elektrolyseanlage führt die verzögerte Freigabe zu einem wirtschaftlich relevanten Effizienzverlust der Anlage. Es besteht das betriebswirtschaftlich begründete Anliegen, die Elektrolyseanlage möglichst schnell produktiv nutzen zu können.

In der Patentschrift DE 10 2020 104 956 B3 wird ein Lösungsansatz für eine vergleichbare Problemstellung beschrieben, bei dem die Parallelschaltung aus dem zu bestimmenden Isolationswiderstand und dem funktionalen Widerstand (Widerstände des Kühlwasser-/Verbrauchswasser-Systems gegen Erde) vermieden wird, indem der funktionale Widerstand als Ankopplung des Isolationsüberwachungssystems genutzt werden. Diese Lösung ist jedoch sehr spezifisch auf die zu überwachende Anlage abgestimmt und schwierig in andere bestehende elektrische Anlagen zu integrieren oder nachzurüsten.

Ein weiteres Problem besteht in der Überwachung des DC-Stromflusses in dem Verbrauchswasserleitungssystem während des Elektrolysevorgangs. Dieser DC-Strom fließt als Ableitstrom über eine Verbrauchswasser-Zuleitung und eine Verbrauchswasser-Ableitung und ist von dem zur Elektrolyse erforderlichen DC-Laststrom über die Elektroden zu unterscheiden.

Bei einem einzelnen Elektrolyseur in einem hinreichend hochohmigen IT-System wird der DC-Strom im Verbrauchswasserleitungssystem selbst bei relativ niederohmigem funktionalem Widerstand des Verbrauchswassers gegen Erde vernachlässigbar klein sein, wenn ein weitgehend symmetrischer Anlagenaufbau für eine symmetrische Spannung der aktiven Leiter gegen Erde sorgt.

Hingegen ist ein hoher DC-Strom im Bereich einiger Ampere bis über 100A im Verbrauchswasserleitungssystem zu erwarten, wenn
ein einseitiger niederohmiger Erdschluss an einem aktiven Leiter des ungeerdeten Stromversorgungssystems entsteht oder
wenn mehrere Elektrolyseure in einem IT-System mit eigenen nicht synchronisierten aktiven Stromrichtern betrieben werden.

Die Überwachung von DC-(Ableit-)Strömen, die über die Verbrauchswasseranschlüsse oder auch über das Kühlwasser abfließen, erfolgt nach dem Stand der Technik mit Differenzstromüberwachungsgeräten.

Im Anwendungsfall der Wasserstoffelektrolyse jedoch gestaltet sich die DC-Differenzstromüberwachung im Verbrauchswasserleitungssystem messtechnisch schwierig und teuer, da die extrem großen DC-Lastströme von einigen 1000A messtechnisch Einfluss auf die Differenzstrommessung des DC-(Ableit-)Stroms im Verbrauchswasserleitungssystem nehmen.

Der vorliegenden Erfindung liegt somit die Aufgabe zu Grunde, den Isolationswiderstand des die Wasserstoffelektrolyseanlage versorgenden ungeerdeten Stromversorgungsystems möglichst frühzeitig im Verlauf des Demineralisierungsprozesses hinreichend genau zu bestimmen - exklusive des elektrisch parallel geschalteten dynamisch sich verändernden elektrischen Widerstands des Verbrauchswassers gegen Erde. Als zusätzlicher Sicherheitsaspekt soll ein möglicher DC-Stromfluss in dem Verbrauchswasserleitungssystem in die Isolationsüberwachung mit einbezogen werden.

Diese Aufgabe wird in einer ersten Alternativlösung durch die Merkmale des in Anspruch 1 beschriebenen Verfahrens gelöst.

Der Grundgedanke des erfindungsgemäßen Verfahrens besteht darin, den Isolationswiderstand des ungeerdeten Stromversorgungssystems - den Isolationswiderstand der Isolierstrecke des ungeerdeten Stromversorgungssystems ohne die weiteren funktonalen, sich dynamisch ändernden elektrischen Widerstände des Verbrauchswassers - während eines initialen Hochfahrvorgangs der Wasserstoffelektrolyseanlage vorherzusagen und damit die durch den Demineralisierungsprozess verursachte Verzögerung bis zur Freischaltung des eigentlichen Elektrolysevorgangs für nachfolgende Hochfahrvorgänge der Elektrolyseanlage möglichst gering zu halten.

Dazu wird zunächst ein initiales Hochfahren der Wasserstoffelektrolyseanlage durchgeführt, beginnend mit einem Demineralisierungsprozess bis ein eingeschwungener Zustand der Demineralisierung des Verbrauchswassers erreicht ist.

Während des Demineralisierungsprozesses erfolgt zu bestimmten Erfassungszeitpunkten tᵢ ein Messen und Speichern einer Anzahl von Gesamt-Isolationswiderstandswerten Rₜₒₜᵢ mittels eines Isolationsüberwachungsgeräts, welches einen von einer Messspannung Uₘ getriebenen Messstrom Iₘ in das ungeerdete Stromversorgungssystem einspeist.

Die Überwachung des ungeerdeten Stromversorgungssystems erfolgt voraussetzungsgemäß mit einem gemäß der Norm IEC61557-8 ausgeführten Isolationsüberwachungsgerät, das zwischen mindestens einen der aktiven Leiter des ungeerdeten Stromversorgungssystems und Erde angekoppelt wird und dem ungeerdeten Stromversorgungssystem eine Messspannung Uₘ überlagert, sodass sich ein dem Isolationsfehler entsprechender Messstrom Iₘ einstellt, dessen Größenordnung typischerweise im µA- bis mA-Bereich liegt.

Das Isolationsüberwachungsgerät misst dabei zu den Erfassungszeitpunkten tᵢ - der Index i spiegelt die zeitliche Abfolge wider - jeweils einen Gesamt-Isolationswiderstandswert Rₜₒₜᵢ, der sich aus der Parallelschaltung des Isolationswiderstands Rᵢₛₒ des IT-Systems und einem zu dem Erfassungszeitpunkt tᵢ vorherrschenden funktionalen Verbrauchswasser-Widerstandswert R_{wi} des Verbrauchswassers zusammensetzt.

Die jeweiligen Verbrauchswasser-Widerstandswerte R_{w1i}, R_{w2i} der Verbrauchswasser-Zuleitung und der Verbrauchswasser-Ableitung können aufgrund ihrer Parallelschaltung mathematisch vereinfachend zu dem funktionalen Verbrauchswasser-Widerstandswert R_{wi} des Verbrauchswassers zusammengefasst werden.

Zum Ende des während des initiales Hochfahrens durchgeführten (initialen) Demineralisierungsprozesses erfolgt im eingeschwungenen Zustand der Demineralisierung ein Messen von Messstromanteilen I_{w1}, I_{w2} in dem Verbrauchswasserleitungssystem mittels hochempfindlicher Stromsensoren.

Der durch das Isolationsüberwachungsgerät fließende Messstrom Iₘ verzweigt sich in einen Messstromanteil Iᵢₛₒ, welcher über den Isolationswiderstand Rᵢₛₒ der Isolierstrecke des ungeerdeten Stromversorgungssystems fließt, und in parallel dazu fließende Messstromanteile I_{w1}, I_{w2} in der Verbrauchswasser-Zuleitung und der Verbrauchswasser-Ableitung. Mittels hochempfindlicher Stromsensoren werden die über das Verbrauchswasserleitungssystem geführten Messstromanteile I_{w1}, I_{w2} erfasst.

Weiter erfolgt im eingeschwungenen Zustand der Demineralisierung ein Berechnen und Speichern des Isolationswiderstands Rᵢₛₒ aus der Messspannung Uₘ, den erfassten Messstromanteilen I_{w1}, I_{w2} und dem Messstrom Iₘ.

Der Isolationswiderstand Rᵢₛₒ wird aus der bekannten Messspannung Uₘ, dem in dem Isolationsüberwachungsgerät erfassten Messstrom Iₘ sowie aus den von den hochempfindlichen Stromsensoren in dem Verbrauchswasserleitungssystem erfassten Messstromanteilen I_{w1}, I_{w2} berechnet.

Für die Erfassungszeitpunkte tᵢ erfolgt anschließend ein Berechnen von Verbrauchswasser-Widerstandswerten R_{wi} aus den Gesamt-Isolationswiderstandswerten Rₜₒₜᵢ und dem Isolationswiderstand Rᵢₛₒ auf Basis der Modellierung der aus den Verbrauchswasser-Widerstandswerten R_{wi} und dem Isolationswiderstand Rᵢₛₒ gebildeten Parallelschaltung.

Nach Beendigung des initialen Demineralisierungsprozesses erfolgt ein Berechnen einer Regressionskurve R_{w}(t) für den Verbrauchswasser-Widerstand R_{w}.

In einem Verfahren der Regressionsanalyse wird auf Basis der Verbrauchswasser-Widerstandswerte R_{wi} die zeitliche Abhängigkeit f(t)=R_{w}(t) des Verbrauchswasser-Widerstands R_{w} beschrieben. So kann beispielsweise nach dem Kriterium der kleinsten Quadrate eine lineare Regressionskurve R_{w}(t) ermittelt werden, aus der für einen beliebigen Bestimmungszeitpunkt T der Regressionswert R_{w}(T) des Verbrauchswasser-Widerstands R_{w} abgelesen werden kann. Wie für die Verbrauchswasser-Widerstandswerte R_{wi} repräsentiert der Verbrauchswasser-Widerstands R_{w} die Parallelschaltung des jeweiligen Verbrauchswasser-Widerstands R_{w1,2} der Verbrauchswasser-Zuleitung und der Verbrauchswasser-Ableitung.

Bei Neustarts der Wasserstoffelektrolyseanlage erfolgt in nachfolgenden regulären Hochfahrvorgängen für einen im Abstand der IMD-Berechnungsperiode zeitlich fortlaufenden Bestimmungszeitpunkt T während des Demineralisierungsprozesses wiederholt eine Berechnung eines erwarteten Isolationswiderstandswerts R'ᵢₛₒ(T) ausgehend von dem Regressionswert R_{w}(T) zum jeweiligen Bestimmungszeitpunkt T und dem mittels des Isolationsüberwachungsgeräts zum jeweiligen Bestimmungszeitpunkt T gemessenen momentanen Gesamt-Isolationswiderstandswert Rₜₒₜ(T).

Somit wird bei weiteren, regulären, betriebsmäßig vorgesehenen Hochfahrvorgängen während des Demineralisierungsprozesses für einen entsprechend der Dauer der IMD-Berechnungsperiode fortschreitenden Bestimmungszeitpunkt T wiederholt eine Berechnung des erwarteten Isolationswiderstandswerts R'ᵢₛₒ(T) durchgeführt. Der erwartete Isolationswiderstandswert R'ᵢₛₒ(T) wird ausgehend von dem aus der Regressionskurve R_{w}(t) entnehmbaren Regressionswert R_{w}(T) und dem von dem Isolationsüberwachungsgerät gemessenen momentanen Gesamt-Isolationswiderstandswert Rₜₒₜ(T) geschätzt, wobei sich der schaltungstechnische Zusammenhang aus der Modellierung der Parallelschaltung aus dem erwarteten Isolationswiderstand R'ᵢₛₒ und dem Verbrauchswasser-Widerstand R_{w} ergibt.

Eine Freischaltung der Wasserstoffelektrolyseanlage erfolgt, sobald im Verlauf der fortlaufenden Berechnung der erwartete Isolationswiderstandswert R'ᵢₛₒ(T) einen vorbestimmten Schwellwert Rₗᵢₘ überschreitet.

Wegen der zu Beginn des Demineralisierungsprozesses höheren elektrischen Leitfähigkeit des Verbrauchswassers werden die von dem Isolationsüberwachungsgerät gemessenen Gesamt-Isolationswiderstandswerte Rₜₒₜᵢ zunächst von dem parallel wirksamen (geringen) Verbrauchswasser-Widerstands R_{w} bestimmt. Im Verlauf des Demineralisierungsprozesses sinkt die elektrische Leitfähigkeit des Verbrauchswassers, wodurch sich der für einen fortschreitenden Bestimmungszeitpunkt T geschätzte erwartete Isolationswiderstandswert R'iso(T) erhöht. Sobald bei fortlaufend wiederholter Berechnung im Verlauf des Demineralisierungsprozesses der erwartete Isolationswiderstandswert R'ᵢₛₒ(T) einen vorbestimmten Schwellwert Rₗᵢₘ überschreitet, erfolgt eine Aufschaltung der Stromversorgung an die Wasserstoffelektrolyseanlage.

In weiterer vorteilhafter Ausgestaltung ermöglichen die Anzahl von Erfassungszeitpunkten tᵢ und deren zeitlicher Abstand eine hinreichend genaue Modellierung durch die Regressionskurve.

Die Anzahl von Erfassungszeitpunkten tᵢ und deren zeitlicher Abstand werden während des Demineralisierungsprozesses des initialen Hochfahrens so gewählt, dass eine mathematische Modellierung durch eine Regressionskurve eine hinreichend genaue und zuverlässige Schätzung des erwartete Isolationswiderstandswerts R'ᵢₛₒ(T) ergibt.

Mit Vorteil werden in Abhängigkeit einer Verbrauchswasser-Temperatur mehrere temperaturangepasste Regressionskurven R_{w}(t) berechnet.

Bei starken Temperaturschwankungen des Verbrauchswassers können an die jeweils herrschende Verbrauchswasser-Temperatur angepasste Regressionskurven R_{w}(t) als Basis für die Bestimmung des Regressionswertes R_{w}(T) dienen.

Weiter wird die Aufgabe in einer zweiten Alternativlösung durch die Merkmale des in Anspruch 4 beschriebenen Verfahrens gelöst.

Im Unterschied zu der in Anspruch 1 beschriebenen ersten Alternativlösung unterscheidet sich diese zweite Alternativlösung dadurch, dass bei dem initialen Hochfahren der Wasserstoffelektrolyseanlage während des Demineralisierungsprozesses zusätzlich der elektrische Leitwert und die Temperatur des Verbrauchswassers von der Demineralisierungsanlage bereitgestellt und anlagenspezifisch erfasst werden.

Anstelle der mittels Regressionsanalyse ermittelten direkten Zeitabhängigkeit wird mit den Größen Gesamt-Isolationswiderstandswert Rₜₒₜᵢ, elektrischer Leitwert Sᵢ und Temperaturwert ϑᵢ eine zeitunabhängige Funktion R_{w}(Rₜₒₜ, S, ϑ) für den Verbrauchswasser-Widerstand R_{w} aufgestellt, die bei nachfolgenden regulären Hochfahrvorgängen für einen zeitlich fortlaufenden Bestimmungszeitpunkt T genutzt wird, um einen erwarteten Isolationswiderstand R'ᵢₛₒ(T) zu berechnen.

Bevorzugt ermöglichen die Anzahl von Erfassungszeitpunkten tᵢ und deren zeitlicher Abstand eine Beschreibung des Verbrauchswasser-Widerstands R_{w} in Abhängigkeit der aufgezeichneten Werte Gesamt-Isolationswiderstandswert Rₜₒₜᵢ, elektrischer Leitwert Sᵢ und Temperaturwert ϑᵢ durch eine zeitunabhängige Funktion R_{w}(Rₜₒₜ, S, ϑ).

Das Messen und Speichern des Gesamt-Isolationswiderstandswertes Rₜₒₜᵢ, des elektrischen Leitwertes Sᵢ und des Temperaturwertes ϑᵢ erfolgen mit einer "Abtastrate" derart, dass hinreichend viele Bestimmungsgleichungen zur Aufstellung eines Gleichungssystems zur Verfügung stehen, aus dem die funktionale Abhängigkeit R_{w}(Rₜₒₜ, S, ϑ) des Verbrauchswasser-Widerstands R_{w} hergeleitet werden kann.

Bevorzugt werden die Messstromanteile I_{w1}, I_{w2} von den hochempfindlichen Stromsensoren im µA- bis mA-Bereich gemessen.

Wegen der messtechnisch negativen Beeinflussung durch den DC-Strom und aufgrund der geringen Stromstärke des eingespeisten Messstroms Iₘ müssen dessen Messstromanteile I_{w1}, I_{w2} hochempfindlich erfasst werden. Dazu eignen sich direkt in dem Verbrauchswasserleitungssystem angeordnete Stromsensoren mit einer Flux-Gate-Stromsensorik im µA- bis mA-Bereich.

Insbesondere bei einem impulsförmigen, getakteten Messstrom Iₘ wird die Amplitudendifferenz (Spitze-Spitze-Wert) der Messstromanteile I_{w1}, I_{w2} ausgewertet, um messtechnisch weitgehend unabhängig von einer absoluten DC-Strombelastung in dem Verbrauchswasserleitungssystem zu sein.

Mit Vorteil wird ein DC-Strom I_{DC1}, I_{DC2} in dem Verbrauchswasserleitungssystem gemessen.

Ergänzend zur Bestimmung des Isolationswiderstands Rᵢₛₒ erfolgt eine Überwachung des DC-Stroms I_{DC1}, I_{DC2}, welcher als Ableitstrom in der Verbrauchswasser-Zuleitung und der Verbrauchswasser-Ableitung des Verbrauchswasserleistungssystems in Erscheinung tritt.

Zum einen kann damit schnell geprüft werden, ob der DC-Strom I_{DC1}, I_{DC2} einen kritischen Wert überschreitet. Eine Gefährdung durch unzulässig hohe Strombelastungen, die beispielsweise bei einem einseitigen niederohmigen Erdschluss an einem aktiven Leiter der DC-Stromversorgung auftreten können und zur Deaktivierung des betroffenen Elektrolyseurs führen, kann somit rechtzeitig erkannt werden.

Zum anderen kann der DC-Arbeitspunkt der - bevorzugt mit Flux-Gate-Sensorik durchgeführten - empfindlichen Messung der Messstromanteile I_{w1}, I_{w2} überwacht werden und damit eine fehlerfreie Bestimmung des Isolationswiderstands Rᵢₛₒ ermöglicht werden.

Vorzugsweise wird der DC-Strom I_{DC1}, I_{DC2} in dem Verbrauchswasserleitungssystem im einstelligen Ampere-Bereich bis zu einer Größenordnung von über 100 Ampere mittels robuster Stromsensoren gemessen.

Die DC-Stromüberwachung ist für die Erfassung von DC-Strömen im einstelligen Amperebereich bis zur Größenordnung über 100A auszulegen. Bevorzugt können hier preiswerte und robuste Halbleiter-Sensoren zum Einsatz kommen.

Weiter erfolgt eine Freischaltung der Wasserstoffelektrolyseanlage nur, falls der DC-Strom I_{DC1}, I_{DC2} einen vorbestimmten Wert nicht überschreitet.

In Verbindung mit der Überwachung des DC-Stroms I_{DC1}, I_{DC2} in der Verbrauchswasser-Zuleitung erfolgt die Freischaltung der Wasserstoffelektrolyseanlage in Form einer UND-Verknüpfung nur dann, wenn die beiden Überwachungsparameter Isolationswiderstand Rᵢₛₒ und DC-Strom I_{DC1}, I_{DC2} jeweils innerhalb eines durch voreinstellbare (Schwell-)Werte gegebenen Bereichs liegen, somit unkritisch sind.

Die der Erfindung zugrundeliegende Aufgabe wird weiter durch eine elektrische Schaltungsanordnung mit den in Anspruch 10 beschriebenen Merkmalen sowie durch eine elektrische Schaltungsanordnung mit den in Anspruch 11 beschriebenen Merkmalen gelöst.

Die elektrischen Schaltungsanordnungen sind zur Umsetzung der erfindungsgemäßen Verfahren zur Bestimmung des Isolationswiderstands Rᵢₛₒ eines die Wasserstoffelektrolyseanlage versorgenden ungeerdeten Stromversorgungssystems ausgelegt.

Die beanspruchten strukturellen Merkmale der erfindungsgemäßen elektrischen Schaltungsanordnungen nach den Ansprüchen 10 und 11 führen dabei die Verfahrensschritte der in den jeweils entsprechenden Ansprüchen 1 und 4 definierten erfindungsgemäßen Verfahren aus. Somit treffen die mit diesen Verfahren erzielten technischen Wirkungen und die daraus resultierenden Vorteile gleichermaßen auch auf die entsprechenden elektrischen Schaltungsanordnungen zu.

Zusammenfassend erlaubt die vorliegende Erfindung einen kostengünstigen Überwachungsansatz mit einfacher Nachrüstmöglichkeit für die Bestimmung des Isolationswiderstands Rᵢₛₒ eines ungeerdeten Stromversorgungssystems für die Versorgung von Wasserstoffelektrolyseanlagen.

Insbesondere besitzen die erfindungsgemäßen Verfahren und die diese Verfahren durchführenden erfindungsgemäßen elektrischen Schaltungsanordnungen in dem funktionalen Zusammenwirken ihrer Merkmale folgende vorteilhafte Eigenschaften:
Eine normgerechte Isolationsüberwachung der Wirksamkeit von Isolierstrecken wird ohne Herabsetzung der normativ empfohlenen Grenzwerte ermöglicht.

Aufwendige und kostenintensive empfindliche Differenzstrommesstechnik im DC-Lastkreis kann durch eine einfacher zu realisierende empfindliche DC-Strommessung im Verbrauchswasserleitungssystem ersetzt werden.

Die kostengünstig zu ergänzende unempfindliche DC-Strommessung im Verbrauchswasserleitungssystem erlaubt die Überwachung des DC-Arbeitspunktes der empfindlichen Strommessung zur Bestimmung des Isolationswiderstands Rᵢₛₒ und ermöglicht die schnelle Erkennung unzulässig hoher, gefährlicher DC-Ströme im Verbrauchswasserleitungssystem.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: schematisch den Aufbau einer Wasserstoffelektrolyseanlage mit Isolationsüberwachung,
- **Fig. 2:**: die Wasserstoffelektrolyseanlage aus Fig. 1 mit ergänzender DC-Stromüberwachung,
- **Fig. 3:**: ein Ersatzschaltbild der Isolationsüberwachung der Wasserstoffelektrolyseanlage,
- **Fig. 4:**: ein Ablaufdiagramm eines erfindungsgemäßen Verfahrens zur Isolationsüberwachung (erste Alternativlösung) und
- **Fig. 5:**: ein Ablaufdiagramm eines weiteren erfindungsgemäßen Verfahrens zur Isolationsüberwachung (zweite Alternativlösung).

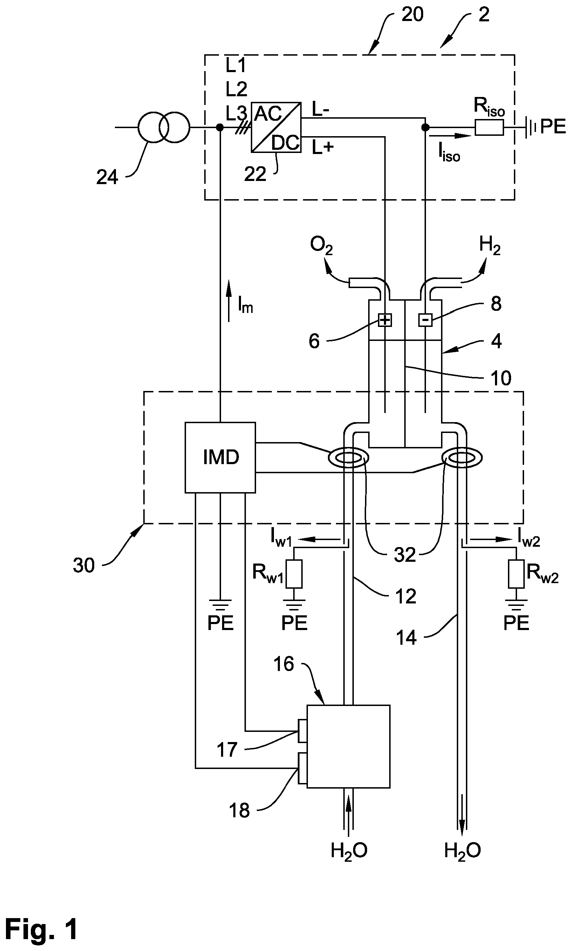

Fig. 1 zeigt schematisch den Aufbau einer Wasserstoffelektrolyseanlage 2 mit Isolationsüberwachung an einem Beispiel der PEM-Elektrolyse.

Die Wasserstoffelektrolyseanlage 2 umfasst eine PEM-Elektrolysezelle 4 mit Elektroden 6, 8 und mit einer Polymermembran 10 sowie mit einer Verbrauchswasser-Zuleitung 12, einer Verbrauchswasser-Ableitung 14 und mit Austritten für den freigesetzten Sauerstoff O₂ und den erzeugten Wasserstoff H₂.

Zur Demineralisierung des Verbrauchswassers H₂O weist die Wasserstoffelektrolyseanlage 2 eine Demineralisierungseinrichtung 16 auf, die eingangs der Verbrauchswasser-Zuleitung 12 angeordnet ist.

Für die in der zweiten Alternativlösung durchzuführende Messung und Speicherung der elektrischen Leitwerte Sᵢ des Verbrauchswassers H₂O und der Temperaturwerte ϑᵢ des Verbrauchswassers H₂O besitzt die Demineralisierungseinrichtung 16 eine Leitwert-Messeinrichtung 17 und eine Temperatur-Messeinrichtung 18.

Die Elektroden 6, 8 werden von einem ungeerdeten Stromversorgungssystem 20 mit elektrischer Energie versorgt. Das ungeerdete Stromversorgungssystem 20 umfasst einen Gleichrichter 22, der von einer 3-phasigen Stromquelle 24 über aktive Leiter L1, L2, L3 gespeist wird. Ausgangsseitig ist der Gleichrichter 22 über die aktiven Leiter L+, L- mit den Elektroden 6, 8 verbunden. Gegen Erde PE weist das ungeerdete Stromversorgungssystem 20 einen Isolationswiderstand Rᵢₛₒ auf.

Grundsätzlich können an das ungeerdete Stromversorgungssystem 20 auch mehrere PEM-Elektrolysezellen 4 angeschlossen sein.

Die Wasserstoffelektrolyseanlage 2 einschließlich der Demineralisierungseinrichtung 16 mit der Leitwert-Messeinrichtung 17 und der Temperatur-Messeinrichtung 18 ebenso wie das ungeerdete Stromversorgungssystem 20 bilden eine vorausgesetzte Anwendungsumgebung für die vorliegende Erfindung und sind nicht Bestandteil der Erfindung.

Aufgabengemäß wird der Isolationswiderstand Rᵢₛₒ des ungeerdeten Stromversorgungssystems 20 mittels einer erfindungsgemäßen elektrischen Schaltungsanordnung 30 überwacht.

Die elektrische Schaltungsanordnung 30 umfasst ein normgerechtes Isolationsüberwachungsgerät IMD entsprechend dem Produktstandard IEC 61557-8, und, pro Verbrauchswasser-Zuleitung 12 und Verbrauchswasser-Ableitung 14 jeder an das ungeerdete Stromversorgungssystem 20 angeschlossenen PEM-Elektrolysezelle 4, zusätzlich je einen hochempfindlichen Stromsensor 32, der geeignet ist, die über die Verbrauchswasserwiderstände R_{w1}, R_{w2} fließenden Messstromanteile I_{w1}, I_{w2} hinreichend genau zu bestimmen. Die hochempfindlichen Stromsensoren 32 sind in diesem Ausführungsbeispiel mit dem Isolationsüberwachungsgerät IMD verbunden, welches sämtliche Berechnungen prozessorgesteuert ausführt.

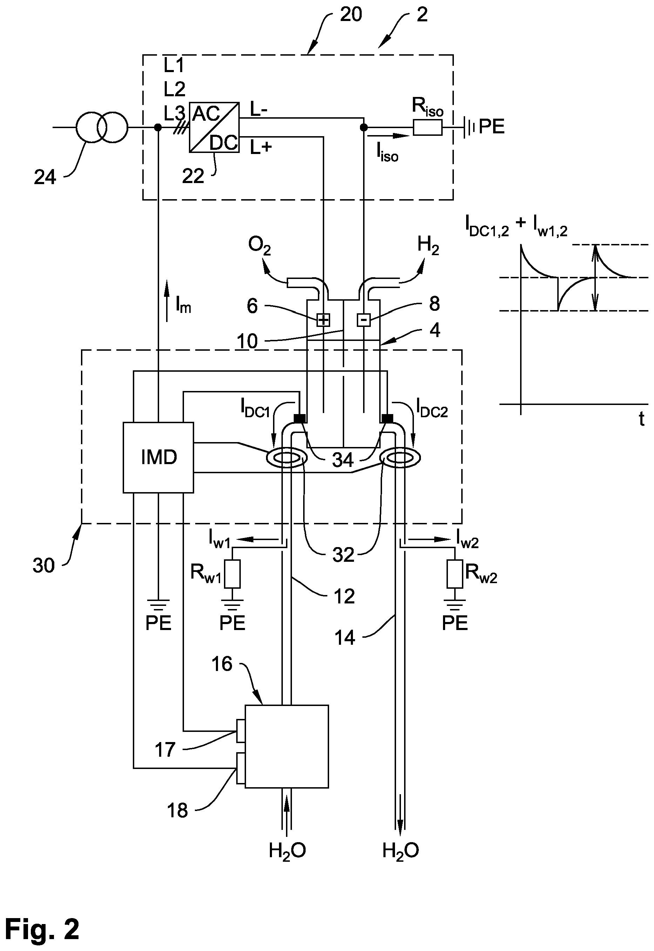

In Fig. 2 ist die Wasserstoffelektrolyseanlage 2 aus Fig. 1 mit ergänzender DC-Stromüberwachung dargestellt.

Dazu ist in der Verbrauchswasser-Zuleitung 12 und der Verbrauchswasser-Ableitung 14 zusätzlich jeweils ein robuster Stromsensor 34 zur Messung des jeweiligen DC-Stroms I_{DC1}, I_{DC2} angeordnet. Die robusten Stromsensoren 34 sind auch hier zur Auswertung der erfassten DC-Ströme I_{DC1}, I_{DC2} mit dem Isolationsüberwachungsgerät IMD verbunden.

Die jeweiligen Messstromanteile I_{w1}, I_{w2} überlagern einen möglichen, im Vergleich zu den Messstromanteilen I_{w1}, I_{w2} relativ hohen, DC-Strom I_{DC1}, I_{DC2}. Anschaulich und nicht maßstäblich dargestellt ist für einen impulsförmigen, getakteten Messstrom Iₘ die Auswertung der Amplitudendifferenz (Spitze-Spitze-Wert) der Messstromanteile I_{w1}, I_{w2}, um die Messung unabhängig von einer absoluten DC-Strombelastung in dem Verbrauchswasserleitungssystem durchzuführen.

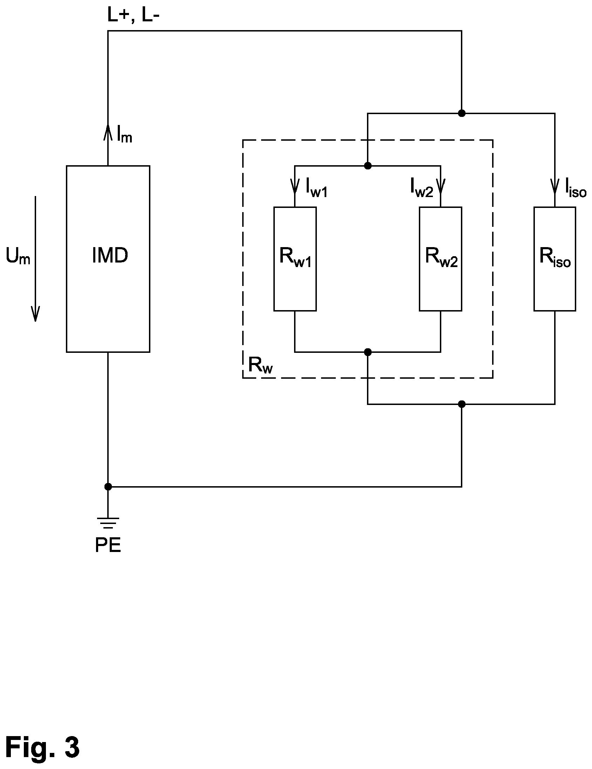

Fig. 3 zeigt ein Ersatzschaltbild der Isolationsüberwachung der von dem ungeerdeten Stromversorgungssystem 20 versorgten Wasserstoffelektrolyseanlage 2. Auf der Grundlage dieses Ersatzschaltbildes wird der korrekte Isolationswiderstand Rᵢₛₒ ermittelt.

Die Verbrauchswasserwiderstände R_{w1}, R_{w2} bilden zusammen mit dem Isolationswiderstand Rᵢₛₒ des ungeerdeten Stromversorgungssystems 20 eine Parallelschaltung. Zur Bestimmung des Isolationswiderstands Rᵢₛₒ wird diese Parallelschaltung von dem Isolationsüberwachungsgerät IMD mit einer Messspannung Uₘ beaufschlagt, die einen Messstrom Iₘ treibt, der sich in die über die Verbrauchswasserwiderstände R_{w1}, R_{w2} fließenden Messstromanteile I_{w1}, I_{w2} und den über den Isolationswiderstand Rᵢₛₒ fließenden Messstromanteil Iᵢₛₒ aufteilt.

Da die Messspannung Uₘ bekannt ist, der Messstrom Iₘ intern von dem Isolationsüberwachungsgerät IMD gemessen wird und die Messstromanteile I_{w1}, I_{w2} von den hochempfindlichen Stromsensoren 32 erfasst werden, kann der über den Isolationswiderstand Rᵢₛₒ fließende Messstromanteil Iᵢₛₒ wie folgt berechnet werden (für das hier betrachtete Ausführungsbeispiel gilt n=2): ${I}_{iso} = {I}_{m} - {\sum }_{x = 1}^{n} {I}_{wx} .$

Der bereinigte und damit korrekte Isolationswiderstand Rᵢₛₒ ergibt sich daraus gemäß $\begin{matrix}{R}_{iso} = \frac{{U}_{m}}{{I}_{iso}} , \\ {R}_{iso} = \frac{{U}_{m}}{{I}_{m} - {\sum }_{x = 1}^{n} {I}_{wx}} .\end{matrix}$

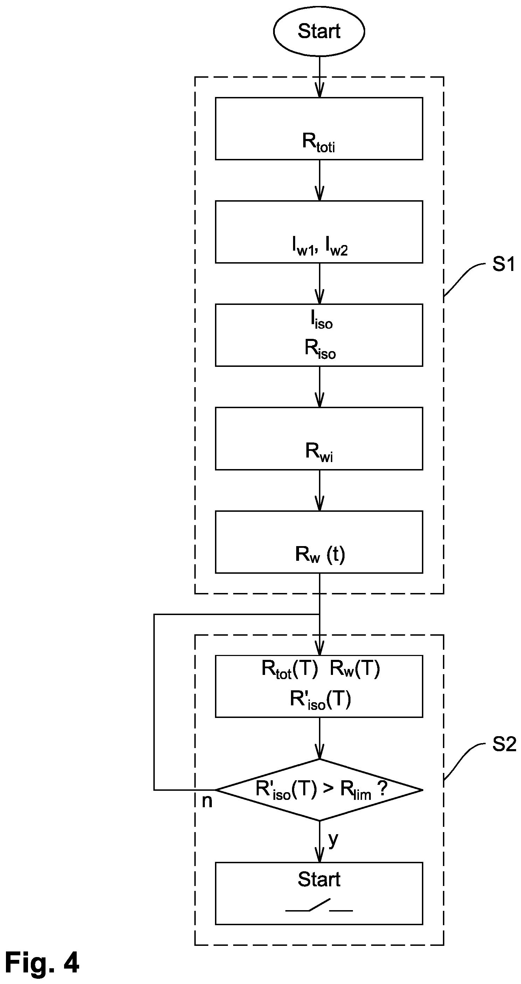

Fig. 4 fasst den erfindungsgemäßen Verfahrensablauf der ersten Alternativlösung nach Anspruch 1 zusammen.

Dabei ist die Bezeichnung der zu verarbeitenden Größen durchgängig mit dem Index i versehen, um zu verdeutlichen, dass es sich um eine zeitliche Folge von gemessenen oder berechneten Werten handelt. So wird beispielsweise der für den Erfassungszeitpunkt tᵢ berechnete Verbrauchswasser-Widerstand R_{w} als Verbrauchswasser-Widerstandswert R_{wi} bezeichnet.

Innerhalb des initialen Hochfahrvorgangs S1 werden zunächst während des Demineralisierungsprozesses Gesamt-Isolationswiderstandswerte Rₜₒₜᵢ mittels des Isolationsüberwachungsgeräts IMD gemessen.

Im eingeschwungenen Zustand der Demineralisierung findet in dem Verbrauchswasserleitungssystem 12, 14 mittels hochempfindlicher Stromsensoren 32 eine Messung der Messstromanteile I_{w1}, I_{w2} statt. Unter Anwendung von Gl. (1) kann der über den Isolationswiderstand Rᵢₛₒ fließende Messstromanteil Iᵢₛₒ berechnet werden und daraus folgt mit Gl. (2) der Isolationswiderstand Rᵢₛₒ.

Da der Isolationswiderstand Rᵢₛₒ somit bekannt ist und der Gesamt-Isolationswiderstandswert Rₜₒₜᵢ gemessen wird, ergibt sich aufgrund der Parallelschaltung des Verbrauchswasser-Widerstands R_{w} mit dem Isolationswiderstand Rᵢₛₒ für die Folge der während des Demineralisierungsprozesses wirkenden Verbrauchswasser-Widerstandswerte R_{wi} ${R}_{wi} = \frac{{R}_{toti} ∗ {R}_{iso}}{{R}_{iso} - {R}_{toti}} .$

Auf Basis der so ermittelten Verbrauchswasser-Widerstandswerte R_{wi} wird eine Regressionskurve R_{w}(t) für den Verbrauchswasser-Widerstand R_{w} erstellt.

Das initiale Hochfahren S1 ist damit abgeschlossen und die gewonnene Regressionskurve R_{w}(t) kann für weitere, betriebsmäßig vorgesehene Hochfahrvorgänge S2 verwendet werden.

Dies geschieht in der Weise, dass in den nachfolgenden Hochfahrvorgängen S2 während des Demineralisierungsprozesses für einen zeitlich fortlaufenden Bestimmungszeitpunkt T die Berechnung eines erwarteten Isolationswiderstandswertes R'ᵢₛₒ(T) erfolgt.

Der Vorhersagewert des erwarteten Isolationswiderstandswertes R'ᵢₛₒ(T) wird unter Einbeziehung des für diesen Bestimmungszeitpunkt T aus der Regressionskurve R_{w}(t) gewonnenen Regressionswertes R_{w}(T) und dem mittels des Isolationsüberwachungsgeräts (IMD) zum jeweiligen Bestimmungszeitpunkt T gemessenen momentanen Gesamt-Isolationswiderstandswert Rₜₒₜ(T) berechnet: $R {′}_{iso} \left(T\right) = \frac{{R}_{tot} \left(T\right) ∗ {R}_{w} \left(T\right)}{{R}_{w} \left(T\right) - {R}_{tot} \left(T\right)} .$

Auf diese Weise kann in nachfolgenden Demineralisierungsprozessen zu einem möglichst frühen Bestimmungszeitpunkt T bereits eine Aussage über einen erwarteten Isolationswiderstandswert R'ᵢₛₒ(T) getroffen werden. Sobald im Verlauf des nachfolgenden Demineralisierungsprozesses der fortlaufend wiederholt berechnete Isolationswiderstandswert R'ᵢₛₒ(T) einen vorbestimmten Schwellwert überschreitet, erfolgt eine Freischaltung der Wasserstoffelektrolyseanlage.

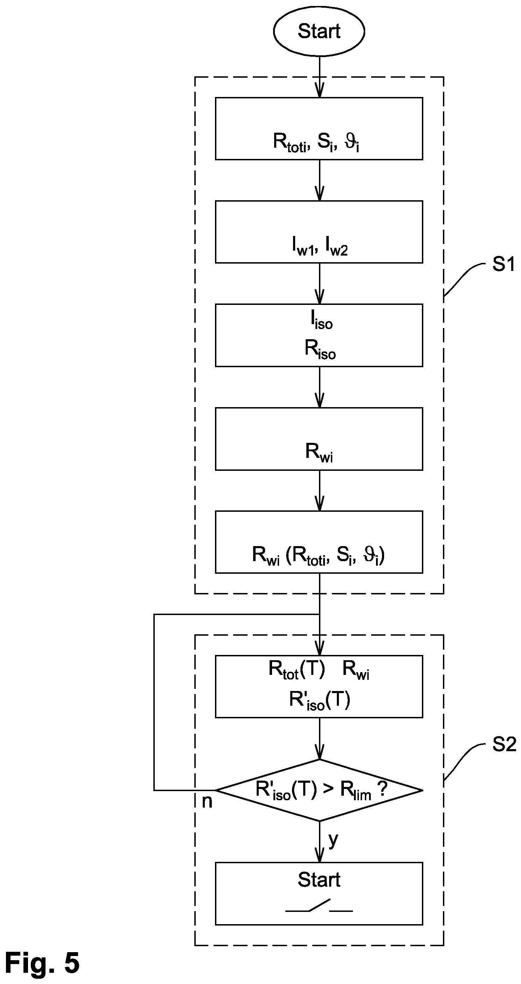

**Fig. 5** zeigt ein Ablaufdiagramm des erfindungsgemäßen Verfahrens zur Isolationsüberwachung gemäß der in Anspruch 4 beschriebenen zweiten Alternativlösung.

Im Unterschied zu der in Fig. 4 gezeigten ersten Alternativlösung werden innerhalb des initialen Hochfahrvorgangs S1 während des Demineralisierungsprozesses zu bestimmten Erfassungszeitpunkten tᵢ neben der Messung und Speicherung des Gesamt-Isolationswiderstandswertes Rₜₒₜᵢ auch der elektrische Leitwert Sᵢ des Verbrauchswassers und der Temperaturwert ϑᵢ des Verbrauchswassers als unabhängige Funktionsparameter erfasst.

An die Stelle der Regressionsanalyse R_{w}(t) aus der ersten Alternativlösung tritt eine zeitunabhängige Funktion R_{w}(Rₜₒₜ, S, ϑ) für den Verbrauchswasser-Widerstand R_{w}, aus der für nachfolgende Hochfahrvorgänge S2 der zum jeweiligen Bestimmungszeitpunkt T wirkende Verbrauchswasser-Widerstandswert R_{w}(T) bestimmt werden kann.

Der analog zu Gl. (4) mit dem durch die zeitunabhängige Funktion R_{w}(Rₜₒₜ, S, ϑ) gegebenen Verbrauchswasser-Widerstand R_{w}(T) fortlaufend berechnete, erwartete Isolationswiderstandswert R'ᵢₛₒ(T) wird dann auf eine Überschreitung eines vorbestimmten Schwellwertes Rₗᵢₘ geprüft.

## Patentansprüche

1. Verfahren zur Bestimmung eines Isolationswiderstands Rᵢₛₒ eines ungeerdeten Stromversorgungssystems (20), welches eine Wasserstoffelektrolyseanlage (2) mit elektrischer Energie versorgt, umfassend die Verfahrensschritte:
initiales Hochfahren (S1) der Wasserstoffelektrolyseanlage (2) beginnend mit einem Demineralisierungsprozess bis ein eingeschwungener Zustand der Demineralisierung des Verbrauchswassers erreicht ist;
während des Demineralisierungsprozesses zu bestimmten Erfassungszeitpunkten tᵢ Messen und Speichern einer Anzahl von Gesamt-Isolationswiderstandswerten Rₜₒₜᵢ mittels eines Isolationsüberwachungsgeräts (IMD), welches einen von einer Messspannung Uₘ getriebenen Messstrom Iₘ in das ungeerdete Stromversorgungssystem (20) einspeist;
im eingeschwungenen Zustand der Demineralisierung Messen von Messstromanteilen I_{w1}, I_{w2} in einem Verbrauchswasserleitungssystem (12, 14) mittels hochempfindlicher Stromsensoren (32);
im eingeschwungenen Zustand der Demineralisierung Berechnen und Speichern des Isolationswiderstands Rᵢₛₒ, aus der Messspannung Uₘ, den erfassten Messstromanteilen I_{w1}, I_{w2} und dem Messstrom Iₘ;
für die Erfassungszeitpunkte ti Berechnen von Verbrauchswasser-Widerstandswerten R_{wi}, aus den Gesamt-Isolationswiderstandswerten Rₜₒₜᵢ und dem Isolationswiderstand Rᵢₛₒ auf Basis einer Modellierung einer aus den Verbrauchswasser-Widerstandswerten R_{wi} und dem Isolationswiderstand Rᵢₛₒ gebildeten Parallelschaltung;
Berechnen einer Regressionskurve R_{w}(t) für den Verbrauchswasser-Widerstand R_{w}, wobei
in nachfolgenden regulären Hochfahrvorgängen (S2) für einen zeitlich fortlaufenden Bestimmungszeitpunkt T während des Demineralisierungsprozesses eine Berechnung eines erwarteten Isolationswiderstandswertes R'ᵢₛₒ(T) erfolgt, ausgehend von einem Regressionswert R_{w}(T) zum jeweiligen Bestimmungszeitpunkt T und einem mittels des Isolationsüberwachungsgeräts (IMD) zum jeweiligen Bestimmungszeitpunkt T gemessenen momentanen Gesamt-Isolationswiderstandswert Rₜₒₜ(T), und
eine Freischaltung der Wasserstoffelektrolyseanlage (2) erfolgt, sobald im Verlauf der fortlaufenden Berechnung der erwartete Isolationswiderstandswert R'ᵢₛₒ(T) einen vorbestimmten Schwellwert Rₗᵢₘ überschreitet.

2. Verfahren nach Anspruch 1,
**dadurch gekennzeichnet,**
**dass** die Anzahl von Erfassungszeitpunkten tᵢ und deren zeitlicher Abstand eine hinreichend genaue Modellierung durch die Regressionskurve R_{w}(t) ermöglichen.

3. Verfahren nach Anspruch 1 oder 2,
**dadurch gekennzeichnet,**
**dass** in Abhängigkeit einer Verbrauchswasser-Temperatur ϑ mehrere temperaturangepasste Regressionskurven R_{w}(t) berechnet werden.

4. Verfahren zur Bestimmung eines Isolationswiderstands Rᵢₛₒ eines ungeerdeten Stromversorgungssystems (20), welches eine Wasserstoffelektrolyseanlage (2) mit elektrischer Energie versorgt, umfassend die Verfahrensschritte:
initiales Hochfahren (S1) der Wasserstoffelektrolyseanlage (2) beginnend mit einem Demineralisierungsprozess bis ein eingeschwungener Zustand der Demineralisierung des Verbrauchswassers erreicht ist;
während des Demineralisierungsprozesses zu bestimmten Erfassungszeitpunkten tᵢ Messen und Speichern einer Anzahl von Gesamt-Isolationswiderstandswerten Rₜₒₜᵢ mittels eines Isolationsüberwachungsgeräts (IMD), welches einen von einer Messspannung Uₘ getriebenen Messstrom Iₘ in das ungeerdete Stromversorgungssystem (20) einspeist, sowie Messen und Speichern von elektrischen Leitwerten Sᵢ des Verbrauchswassers und von Temperaturwerten ϑᵢ des Verbrauchswassers; im eingeschwungenen Zustand der Demineralisierung Messen von Messstromanteilen I_{w1}, I_{w2} in einem Verbrauchswasserleitungssystem (12, 14) mittels hochempfindlicher Stromsensoren (32);
im eingeschwungenen Zustand der Demineralisierung Berechnen und Speichern des Isolationswiderstands Rᵢₛₒ, aus der Messspannung Uₘ, den erfassten Messstromanteilen I_{w1}, I_{w2} und dem Messstrom Iₘ;
für die Erfassungszeitpunkte ti Berechnen von Verbrauchswasser-Widerstandswerten R_{wi} aus den Gesamt-Isolationswiderstandswerten Rₜₒₜᵢ und dem Isolationswiderstand Rᵢₛₒ auf Basis einer Modellierung einer aus den Verbrauchswasser-Widerstandswerten R_{wi} und dem Isolationswiderstand Rᵢₛₒ gebildeten Parallelschaltung;
Berechnen einer zeitunabhängigen Funktion R_{w}(Rₜₒₜ, S, ϑ) für den Verbrauchswasser-Widerstand R_{w}, wobei
in nachfolgenden regulären Hochfahrvorgängen für einen zeitlich fortlaufenden Bestimmungszeitpunkt T während der Demineralisierungsphase eine Berechnung eines erwarteten Isolationswiderstands R'ᵢₛₒ(T) erfolgt, ausgehend von dem durch die zeitunabhängige Funktion R_{w}(Rₜₒₜ, S, ϑ) gegebenen Verbrauchswasser-Widerstand R_{w}(T) zum jeweiligen Bestimmungszeitpunkt T und einem mittels des Isolationsüberwachungsgeräts (IMD) zum jeweiligen Bestimmungszeitpunkt T gemessenen momentanen Gesamt-Isolationswiderstandswert Rₜₒₜ(T), und eine Freischaltung der Wasserstoffelektrolyseanlage (2) erfolgt, sobald im Verlauf der fortlaufenden Berechnung der erwartete Isolationswiderstand R'ᵢₛₒ(T) einen vorbestimmten Schwellwert Rₗᵢₘ überschreitet.

5. Verfahren nach Anspruch 4,
**dadurch gekennzeichnet,**
**dass** die Anzahl von Erfassungszeitpunkten tᵢ und deren zeitlicher Abstand eine Beschreibung des Verbrauchswasser-Widerstands R_{w} in Abhängigkeit der aufgezeichneten Werte Gesamt-Isolationswiderstandswert Rₜₒₜᵢ, elektrischer Leitwert Sᵢ und Temperaturwert ϑᵢ durch eine zeitunabhängige Funktion R_{w}(Rₜₒₜ, S, ϑ) ermöglichen.

6. Verfahren nach einem der Ansprüche 1 bis 5,
**dadurch gekennzeichnet,**
**dass** die Messstromanteile I_{w1}, I_{w2} von den hochempfindlichen Stromsensoren im µA- bis mA-Bereich gemessen werden.

7. Verfahren nach einem der Ansprüche 1 bis 6,
**dadurch gekennzeichnet,**
**dass** ein DC-Strom I_{DC1}, I_{DC2} in dem Verbrauchswasserleitungssystem (12, 14) gemessen wird.

8. Verfahren nach Anspruch 7,
**dadurch gekennzeichnet,**
**dass** der DC-Strom I_{DC1}, I_{DC2} in dem Verbrauchswasserleitungssystem (12, 14) im einstelligen Ampere-Bereich bis zu einer Größenordnung von über 100 Ampere mittels robuster Stromsensoren gemessen wird

9. Verfahren nach einem der Ansprüche 1 bis 8,
**dadurch gekennzeichnet,**
**dass** eine Freischaltung der Wasserstoffelektrolyseanlage (2) nur erfolgt, falls der DC-Strom I_{DC1}, I_{DC2} einen vorbestimmten Wert nicht überschreitet.

10. Elektrische Schaltungsanordnung (30)zur Bestimmung eines Isolationswiderstands Rᵢₛₒ eines ungeerdeten Stromversorgungssystems (20), welches eine Wasserstoffelektrolyseanlage (2) mit elektrischer Energie versorgt,
mit einem dem Produktstandard IEC 61557-8 entsprechenden Isolationsüberwachungsgerät (IMD) zur Messung und Speicherung einer Anzahl von Gesamt-Isolationswiderstandswerten Rₜₒₜᵢ, welches ausgelegt ist, die in Anspruch 1 beschriebenen Berechnungen auszuführen,
und mit jeweils einem in einer Verbrauchswasser-Zuleitung (12) und einer Verbrauchswasser-Ableitung (14) angeordneten hochempfindlichen Stromsensor (32).

11. Elektrische Schaltungsanordnung (30) zur Bestimmung eines Isolationswiderstands Rᵢₛₒ eines ungeerdeten Stromversorgungssystems (20), welches eine Wasserstoffelektrolyseanlage mit elektrischer Energie versorgt,
mit einem dem Produktstandard IEC 61557-8 entsprechenden Isolationsüberwachungsgerät (IMD) zur Messung und Speicherung einer Anzahl von Gesamt-Isolationswiderstandswerten Rₜₒₜᵢ, welches ausgelegt ist, die in Anspruch 4 beschriebenen Berechnungen auszuführen, und mit jeweils einem in einer Verbrauchswasser-Zuleitung (12) und einer Verbrauchswasser-Ableitung (14) angeordneten hochempfindlichen Stromsensor (32).

12. Elektrische Schaltungsanordnung nach Anspruch 10 oder 11,
**dadurch gekennzeichnet,**
**dass** die hochempfindlichen Stromsensoren zur Messung der Messstromanteile I_{w1}, I_{w2} als Stromsensorik für Messungen im µA- bis mA-Bereich ausgelegt sind.

13. Elektrische Schaltungsanordnung nach einem der Ansprüche 10 bis 12, **gekennzeichnet durch**
eine robuste Stromsensorik zur Messung eines DC-Stroms I_{DC} in dem Verbrauchswasserleitungssystem (12, 14), welche für Messungen im einstelligen Ampere-Bereich bis zu einer Größenordnung von über 100 Ampere ausgelegt ist.

## Claims

1. A method for determining an insulation resistance Rᵢₛₒ of an ungrounded power supply system (20), which feeds electrical energy to a water-electrolysis installation (2), the method comprising the steps:
initially booting (S1) the water-electrolysis installation (2) starting with a demineralization process until a steady state of the demineralization of the process water has been achieved;
during the demineralization process, measuring and saving a number of total insulation-resistance values Rₜₒₜᵢ at specific registration times tᵢ by means of an insulation monitoring device (IMD), which feeds a measuring current Iₘ driven by a measuring voltage Uₘ to the ungrounded power supply system (20);
measuring measuring-current portions I_{w1}, I_{w2} in a process-water pipe system (12, 14) by means of highly sensitive current sensors (32) in the steady state of the demineralization;
computing and storing insulation resistance Rᵢₛₒ from measuring voltage Uₘ, registered measuring-current portions I_{w1}, I_{w2} and measuring current Iₘ in the steady state of the demineralization;
computing process-water resistance values R_{wi} from total insulation-resistance values Rₜₒₜᵢ and insulation resistance Rᵢₛₒ for registration times tᵢ based on a modeling of a parallel circuit formed by process-water resistance values R_{wi} and insulation resistance Rᵢₛₒ;
computing a regression curve R_{w}(t) for process-water resistance R_{w}, an expected insulation-resistance value R'ᵢₛₒ(T) being computed in subsequent regular booting processes (S2) for a temporally consecutive determination time T during the demineralization process, starting from a regression value R_{w}(t) at respective determination time T and from a current total insulation-resistance value Rₜₒₜ(T) measured by means of the insulation monitoring device (IMD) at respective determination time T; and
the water-electrolysis installation (2) being cleared as soon as expected insulation-resistance value R'ᵢₛₒ(T) has exceeded a predetermined threshold value Rₗᵢₘ in the progression of the continuous computation.

2. The method according to claim 1,
**characterized in that**
the number of registration times tᵢ and their temporal interval allow a sufficiently precise modeling via the regression curve R_{w}(t).

3. The method according to claim 1 or 2,
**characterized in that**
several temperature-adapted regression curves R_{w}(t) are computed as a function of a process-water temperature ϑ.

4. A method for determining an insulation resistance Rᵢₛₒ of an ungrounded power supply system (20), which feeds electrical energy to a water-electrolysis installation (2), the method comprising the following steps:
initially booting (S1) the water-electrolysis installation (2) starting with a demineralization process until a steady state of the demineralization of the process water has been achieved;
during the demineralization process, measuring and storing a number of total insulation resistance values Rₜₒₜᵢ at specific registration times tᵢ by means of an insulation monitoring device (IMD), which feeds a measuring current Iₘ driven by a measuring voltage Uₘ to the ungrounded power supply system (20), as well as measuring and storing electric conductance values Sᵢ of the process water and of temperature values ϑᵢ of the process water;
measuring measuring-current portions I_{w1}, I_{w2} in a process-water pipe system (12, 14) by means of highly sensitive current sensors (32) in the steady state of the demineralization;
computing and storing insulation resistance Rᵢₛₒ from measuring voltage Uₘ, registered measuring-current portions I_{w1}, I_{w2} and measuring current Iₘ in the steady state of the demineralization;
computing process-water resistance values R_{wi} from total insulation-resistance values Rₜₒₜᵢ and insulation resistance Rᵢₛₒ for registration times tᵢ based on a modeling of a parallel circuit formed by process-water resistance values R_{wi} and insulation resistance Rᵢₛₒ;
computing a time-independent function R_{w}(Rₜₒₜ, S, ϑ) for process-water resistance R_{w},
an expected insulation resistance R'ᵢₛₒ(T) being computed in subsequent regular booting processes for a temporally consecutive determination time T during the demineralization phase, starting from process-water resistance R_{w}(T) given by time-independent function R_{w}(Rₜₒₜ, S, ϑ) at respective determination time T and from a current total insulation-resistance value Rₜₒₜ(T) measured by means of the insulation monitoring device (IMD) at the respective determination time T; and
the water-electrolysis installation (2) being cleared as soon as expected insulation-resistance R'ᵢₛₒ(T) has exceeded a predetermined threshold value Rₗᵢₘ in the progression of the continuous computation.

5. The method according to claim 4,
**characterized in that**
the number of registration times tᵢ and their temporal interval allow a description of process-water resistance R_{w} as a function of the recorded values total insulation-resistance value Rₜₒₜᵢ, electric conductance value Sᵢ and temperature value ϑᵢ via a time-independent function R_{w}(Rₜₒₜ, S, ϑ).

6. The methods according to any one of the claims 1 to 5,
**characterized in that**
measuring-current portions I_{w1}, I_{w2} are measured by the highly sensitive current sensors in the µA to mA range.

7. The methods according to any one of the claims 1 to 6,
**characterized in that**
a direct current I_{DC1}, I_{DC2} is measured in the process-water pipe system (12, 14).

8. The method according to claim 7,
**characterized in that**
direct current I_{DC1}, I_{DC2} is measured in the process-water pipe system (12, 14) in the single-digit ampere range to a magnitude of over 100 Amperes by means of robust current sensors.

9. The methods according to any one of the claims 1 to 8,
**characterized in that**
the water-electrolysis installation (2) is only cleared should direct current I_{DC1}, I_{DC2} not exceed a predetermined value.

10. An electrical circuit arrangement (30) for determining an insulation resistance Rᵢₛₒ of an ungrounded power supply system (20), which feeds electrical energy to a water-electrolysis installation (2),
the electrical circuit arrangement (30) having an insulation monitoring device (IMD) according to product standard IEC 61557-8 which serves for measuring and storing a number of total insulation-resistance values Rₜₒₜᵢ and is designed to execute the computations described in Claim 1, and having a highly sensitive current sensor (32) disposed in both a process-water supply pipe (12) and a process-water drain pipe (14).

11. An electrical circuit arrangement (30) for determining an insulation resistance Rᵢₛₒ of an ungrounded power supply system (20), which feeds electrical energy to a water-electrolysis installation,
the electrical circuit arrangement (30) having an insulation monitoring device (IMD) according to product standard IEC 61557-8 which serves for measuring and storing a number of total insulation-resistance values Rₜₒₜᵢ and is designed to execute the computations described in Claim 4, and having a highly sensitive current sensor (32) disposed in both a process-water supply pipe (12) and a process-water drain pipe (14).

12. The electrical circuit arrangements according to claim 10 or 11,
**characterized in that**
the highly sensitive current sensors for measuring measuring-current portions I_{w1}, I_{w2} are designed as current sensor technology for measurements in the range of µA to mA.

13. The electrical circuit arrangements according to any one of the claims 10 to 12,
**characterized by**
a robust current sensor technology which serves for measuring a direct current I_{DC} in the process-water pipe system (12, 14) and is designed for measurements in the single-digit ampere range to a magnitude of over 100 Amperes.

## Revendications

1. Procédé permettant de déterminer la résistance d'isolement Rᵢₛₒ d'un système (20) d'alimentation en courant qui n'est pas mis à la terre et qui alimente une installation (2) d'électrolyse de l'eau en énergie électrique, le procédé comprenant les étapes suivantes :
l'amorçage (S1) initial de l'installation (2) d'électrolyse de l'eau en commençant par un procédé de déminéralisation jusqu'à ce qu'un régime permanent de déminéralisation de l'eau de consommation est atteint ;
pendant le procédé de déminéralisation, la mesure et l'enregistrement d'un certain nombre de valeurs totales Rₜₒₜᵢ de résistances d'isolement à des instants d'enregistrement tᵢ spécifiques au moyen d'un dispositif (IMD) de surveillance d'isolement, qui alimente le système (20) d'alimentation en courant non mis à la terre en courant de mesure Iₘ commandé par une tension de mesure Uₘ ;
la mesure des composantes du courant de mesure I_{w1}, I_{w2} dans un système (12, 14) de conduite d'eau de consommation au moyen de capteurs de courant (32) hautement sensibles en régime permanent de la déminéralisation ;
le calcul et l'enregistrement de la résistance d'isolement Rᵢₛₒ à partir de la tension de mesure Uₘ, des composantes enregistrées du courant de mesure I_{w1}, I_{w2} et du courant de mesure Iₘ en régime permanent de la déminéralisation ;
le calcul des valeurs de résistance R_{wi} de l'eau de consommation à partir des valeurs totales Rₜₒₜᵢ de résistances d'isolement et de la résistance d'isolement Rᵢₛₒ pour des instants d'enregistrement tᵢ, sur la base d'une modélisation d'un montage en parallèle formé par les valeurs de résistance R_{wi} de l'eau de consommation et la résistance d'isolement Rᵢₛₒ ;
le calcul d'une courbe de régression R_{w}(t) pour la résistance de l'eau de consommation R_{w},
une valeur attendue de la résistance d'isolement R'ᵢₛₒ(T) étant calculée lors de procédés d'amorçage (S2) réguliers successifs pour un temps de détermination T consécutif pendant du procédé de déminéralisation, à partir d'une valeur de régression R_{w}(t) au temps de détermination T respectif et d'une valeur totale actuelle de la résistance d'isolement Rₜₒₜ(T) mesurée au moyen du dispositif (IMD) de surveillance d'isolement au temps de détermination T respectif ; et
l'installation (2) d'électrolyse de l'eau étant mise en service dès que la valeur attendue de la résistance d'isolement R'ᵢₛₒ(T) a dépassé une valeur de seuil Rₗᵢₘ prédéterminée au cours de l'évolution du calcul continu.

2. Procédé selon la revendication 1,
**caractérisé en ce que**
le nombre d'instants d'enregistrement tᵢ et leur intervalle temporel permettent une modélisation suffisamment précise au moyen de la courbe de régression R_{w}(t).

3. Procédé selon la revendication 1 ou la revendication 2,
**caractérisé en ce que**
plusieurs courbes de régression R_{w}(t) adaptées à la température sont calculées en fonction d'une température de l'eau de consommation ϑ.

4. Procédé permettant de déterminer une résistance d'isolement Rᵢₛₒ d'un système (20) d'alimentation en courant qui est n'est pas mis à la terre et qui alimente une installation (2) d'électrolyse de l'eau en énergie électrique, le procédé comprenant les étapes suivantes :
l'amorçage (S1) initial de l'installation (2) d'électrolyse de l'eau en commençant par un procédé de déminéralisation jusqu'à ce qu'un régime permanent de déminéralisation de l'eau de consommation est atteint ;
pendant le procédé de déminéralisation, la mesure et l'enregistrement d'un nombre de valeurs totales de résistance d'isolement Rₜₒₜᵢ à des instants d'enregistrement tᵢ spécifiques au moyen d'un dispositif (IMD) de surveillance d'isolement, qui alimente le système (20) d'alimentation en courant non mis à la terre en courant de mesure Iₘ commandé par une tension de mesure Uₘ, ainsi que la mesure et l'enregistrement des conductances électriques Sᵢ de l'eau de consommation et des valeurs de température ϑᵢ de l'eau de consommation ;
la mesure des composantes du courant de mesure I_{w1}, I_{w2} dans un système (12, 14) de conduite d'eau de consommation au moyen de capteurs de courant (32) hautement sensibles en régime permanent de la déminéralisation ;
le calcul et l'enregistrement de la résistance d'isolement Rᵢₛₒ à partir de la tension de mesure Uₘ, des composantes enregistrées du courant de mesure I_{w1}, I_{w2} et du courant de mesure Iₘ en régime permanent de la déminéralisation ;
le calcul des valeurs de résistance de l'eau de consommation R_{wi} à partir des valeurs totales de résistances d'isolement Rₜₒₜᵢ et de la résistance d'isolement Rᵢₛₒ pour des instants d'enregistrement tᵢ sur la base d'une modélisation d'un montage en parallèle formé par les valeurs de résistance de l'eau de consommation R_{wi} et la résistance d'isolement Rᵢₛₒ ;
le calcul d'une fonction R_{w}(Rₜₒₜ, S, ϑ) indépendante du temps pour la résistance R_{w} de l'eau de consommation,
une résistance d'isolement R'ᵢₛₒ(T) attendue étant calculée lors de procédés d'amorçage réguliers successifs pour un temps de détermination T consécutif pendant la phase de déminéralisation, à partir de la résistance R_{w}(T) de l'eau de consommation donnée par la fonction R_{w}(Rₜₒₜ, S, ϑ) indépendante du temps aux temps de détermination T respectifs et à partir d'une valeur totale actuelle de la résistance d'isolement Rₜₒₜ(T) mesurée au moyen du dispositif (IMD) de surveillance d'isolement aux temps de détermination T respectifs ; et
l'installation (2) d'électrolyse de l'eau étant mise en service dès que la résistance d'isolement R'ᵢₛₒ(T) attendue a dépassé une valeur de seuil Rₗᵢₘ prédéterminée au cours de l'évolution du calcul continu.

5. Procédé selon la revendication 4,
**caractérisé en ce que**
le nombre d'instants d'enregistrement tᵢ et leur intervalle temporel permettent de décrire la résistance R_{w} de l'eau de consommation en fonction des valeurs enregistrées de la résistance d'isolement totale Rₜₒₜᵢ, de la conductance électrique Sᵢ et de la valeur de température ϑᵢ par l'intermédiaire d'une fonction R_{w}(Rₜₒₜ, S, ϑ) indépendante du temps.

6. Procédés selon l'une quelconque des revendications 1 à 5,
**caractérisé en ce que**
des composantes du courant de mesure I_{w1}, I_{w2} sont mesurées par des capteurs de courant hautement sensibles dans la plage de µA à mA.

7. Procédés selon l'une quelconque des revendications 1 à 6, **caractérisés en ce**
**qu'**un courant continu I_{DC1}, I_{DC2} est mesuré dans le système (12, 14) de conduite d'eau de consommation.

8. Procédé selon la revendication 7,
**caractérisé en ce que**
le courant continu I_{DC1}, I_{DC2} est mesuré dans le système (12, 14) de conduite d'eau de consommation dans la plage des ampères à un chiffre jusqu'à une amplitude supérieure à 100 ampères au moyen de capteurs de courant robustes.

9. Procédés selon l'une quelconque des revendications 1 à 8,
**caractérisés en ce que**
l'installation (2) d'électrolyse de l'eau n'est mise en service que si le courant continu I_{DC1}, I_{DC2} ne dépasse pas une valeur prédéterminée.

10. Agencement de circuit (30) électrique destiné à déterminer une résistance d'isolement Rᵢₛₒ d'un système (20) d'alimentation en courant qui est n'est pas mis à la terre et qui alimente une installation (2) d'électrolyse de l'eau en énergie électrique,
le montage électrique (30) ayant un dispositif (IMD) de surveillance de l'isolement qui conforme à la norme de produit CEI 61557-8 et qui sert à mesurer et à stocker un nombre de valeurs totales de résistances d'isolement Rₜₒₜᵢ et qui est conçu pour exécuter les calculs décrits dans la revendication 1,
et ayant un capteur de courant (32) hautement sensible disposé à la fois dans une amenée (12) d'eau de consommation et dans un écoulement (14)d'eau de consommation.

11. Agencement de circuit (30) électrique pour déterminer une résistance d'isolement Rᵢₛₒ d'un système (20) d'alimentation en courant qui n'est pas mis à la terre et qui alimente une installation d'électrolyse de l'eau en énergie électrique,
l'agencement de circuit (30) électrique ayant un dispositif (IMD) de surveillance d 'isolement qui conforme à la norme de produit CEI 61557-8 et qui sert à mesurer et à stocker un nombre de valeurs totales de résistances d'isolement Rₜₒₜᵢ et qui est conçu pour exécuter les calculs décrits dans la revendication 4, et
ayant un capteur de courant (32) hautement sensible disposé à la fois dans une amenée (12) d'eau de consommation et dans un écoulement (14) d'eau de consommation.

12. Agencement de circuit (30) électrique selon les revendications 10 à 11,
**caractérisé en ce que**
les capteurs de courant hautement sensibles destinés à mesurer les composantes du courant de mesure I_{w1}, I_{w2} sont conçus selon une technologie de capteurs de courant permettant des mesures dans la plage de µA à mA.

13. Circuit électrique (30) selon l'une quelconque des revendications 10 à 12,
**caractérisé par**
une technologie robuste de capteurs de courant servant à mesurer un courant continu I_{DC} dans le système (12, 14) de conduite d'eau de consommation et conçue pour des mesures dans la plage des ampères à un chiffre jusqu'à une intensité supérieure à 100 ampères.
